# FASCICULE DE BREVET EUROPEEN

(11) **EP 2 434 852 B1**
(45) Date de publication et mention de la délivrance du brevet: **16.05.2018**
(21) Numéro de dépôt: 11306186.5
(22) Date de dépôt: 22.09.2011
(51) Int. Cl.: H05K 7/14, H05K 9/00

(54) **Ensemble électronique comprenant un tiroir et un coffre pour la réception de cartes électroniques**
Elektronische Anordnung umfassend einen Einschub und sein Aufnahmestruktur zur Aufnahme von elektronischen Karten
Electronic assembly comprising a drawer and its receptacle for receiving electronic cards

(30) Priorité: 27.09.2010 FR 1057773
(43) Date de publication de la demande: 28.03.2012
(73) Titulaire: ALSTOM Transport Technologies, 93400 Saint-Ouen (FR)
(72) Inventeur: Ruque, Christian, 69960 CORBAS (FR); Faucheux, Grégory, 69270 FONTAINES SUR SAONE (FR)
(74) Mandataire: Lavoix

(56) Documents cités:
- EP-A1- 0 785 706
- EP-A1- 1 732 374
- US-A1- 2002 101 725
- US-B1- 6 574 103
- US-B1- 6 879 496

## Description

La présente invention concerne un ensemble électronique, du type comprenant :
- un tiroir comprenant des emplacements de réception de cartes électroniques insérables de manière amovible dans le tiroir ;
- un coffre comprenant un support de tiroir présentant une ouverture d'insertion à l'avant du support de tiroir et un support de connectique à l'arrière du support de tiroir, le tiroir étant insérable de manière amovible dans le support de tiroir de l'avant vers l'arrière, suivant une direction longitudinale ;
- une première partie de connecteur de coffre associé à chaque emplacement de carte, fixée sur le support de connectique et prévue pour être enfichée avec une deuxième partie de connecteur de coffre fixée sur une carte du fait de l'insertion du tiroir équipé de la carte dans le support de tiroir.

Un tel ensemble électronique permet de connecter, respectivement déconnecter, les parties mâle et femelle des connecteurs de coffre du fait de l'insertion, respectivement l'extraction, du tiroir équipé de cartes électroniques dans le coffre, respectivement hors du coffre. Un tel ensemble électronique est généralement désigné comme étant à « embrochage et débrochage automatique». Les termes « embrochage » et « débrochage » désignent la connexion, respectivement la déconnexion, des parties mâle et femelle d'un connecteur.

Les brevets EP 0 785 706 et EP 1 732 374 divulguent de tels ensembles électroniques à embrochage et débrochage automatique. Dans ces ensembles électroniques, les connecteurs de coffre sont disposés au fond du coffre et leur connexion se fait en aveugle lors de l'insertion du tiroir équipé des cartes dans le coffre.

Les connecteurs utilisés pour ces connexions en aveugle présentent une immunité satisfaisante vis-à-vis des perturbations électromagnétiques.

Néanmoins, du fait de l'utilisation croissante de nouveaux types de connexions plus exigeants, notamment de connexions réseau du type Ethernet, il est nécessaire d'augmenter le niveau d'immunité contre les perturbations électromagnétiques, ou « niveau de blindage électromagnétique ».

Un but de l'invention est de proposer un ensemble électronique à embrochage et débrochage automatique présentant une immunité aux perturbations électromagnétiques améliorées.

A cet effet, cette invention propose un ensemble électronique du type précité, caractérisé en ce qu'il comprend au moins un écran de protection électromagnétique prévu pour être adjacent à une première partie de connecteur de coffre et propre à réaliser une liaison électrique entre le support de tiroir ou le support de connectique et une carte disposée dans l'emplacement associée à la première partie de connecteur de coffre lorsque le tiroir est inséré dans le coffre.

Selon d'autres modes de réalisation, l'ensemble électronique comprend une ou plusieurs des caractéristiques suivantes, prise(s) isolément ou toutes les combinaisons techniquement possibles :
- l'écran s'étend vers l'arrière et/ou vers l'avant à partir du support de connectique par rapport à la direction longitidinale ;
- l'écran est configuré pour séparer physiquement deux premières parties connecteurs de coffre adjacentes en définissant entre elles une cloison de séparation dans le fond du coffre ;
- l'écran comprend au moins une partie fixe fixée sur le support de connectique ;
- l'écran comprend au moins une partie mobile fixée sur une carte ou sur le tiroir ;
- la partie fixe et la partie mobile sont complémentaires et se connectent électriquement lors de l'insertion du tiroir équipé des cartes dans le coffre pour former l'écran ;
- un joint de continuité électromagnétique disposé de façon que la partie fixe et la partie mobile se connectent électriquement par l'intermédiaire de ce joint de continuité électromagnétique ;
- le joint de continuité électromagnétique est disposé sur la partie fixe ou sur la partie mobile ;
- un écran comprend une pièce comprenant une portion de protection prévue pour s'étendre le long d'un connecteur de coffre et une portion de fixation de la portion de protection, faisant un angle avec la portion de protection, notamment un angle d'environ 90°;
- la portion de protection et la portion de fixation définissent une forme en « T » ou en « L » ;
- un écran comprenant une plaque sensiblement plane ; et
- au moins une carte électronique insérable dans un emplacement du tiroir et comprenant une deuxième partie de connecteur de coffre complémentaire de la première partie de connecteur de coffre associée à l'emplacement.

L'invention concerne également une carte électronique pour la réalisation d'un ensemble électronique tel que défini ci-dessus, comprenant une deuxième partie de connecteur de coffre complémentaire d'une première partie de connecteur de coffre associée à un emplacement du tiroir.

Dans un mode de réalisation, la carte électronique comprend au moins une partie mobile d'écran de protection électromagnétique adjacente à la deuxième partie de connecteur de coffre.

L'invention concerne également l'utilisation d'un ensemble électronique tel que défini ci-dessus pour la connexion d'une carte électronique.

L'invention et ses avantages seront mieux compris à la lecture de la description qui va suivre, donnée uniquement à titre d'exemple, et faite en référence aux dessins annexés, sur lesquels :
- les figures 1 et 2 sont des vues en coupe respectivement de côté et de dessus d'un ensemble électronique conforme à l'invention, dans une configuration éclatée ;
- la figure 3 est une vue en coupe de dessus de l'ensemble électronique des figures 1 et 2 en configuration assemblée ;
- les figures 4 et 5 sont des vues en coupe de dessus d'un ensemble électronique selon un deuxième mode de réalisation, respectivement en configuration éclatée et en configuration assemblée.

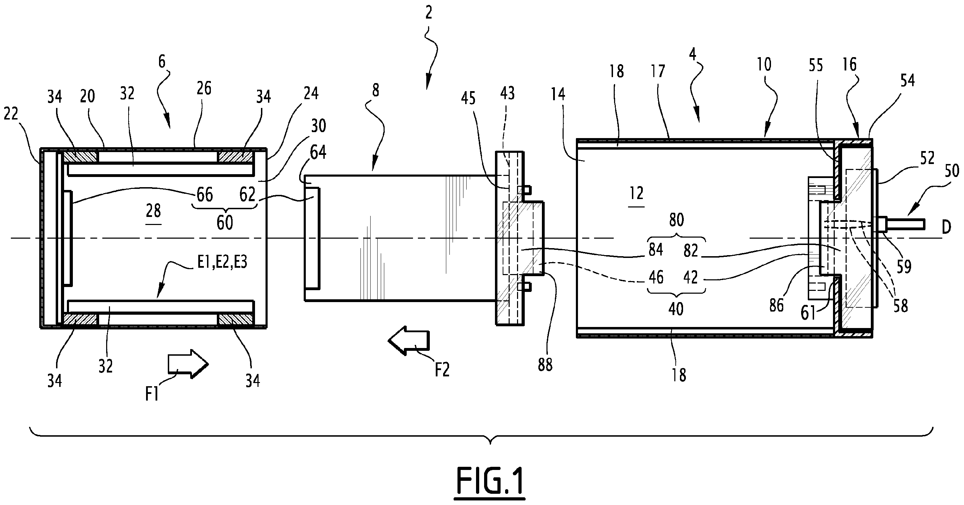

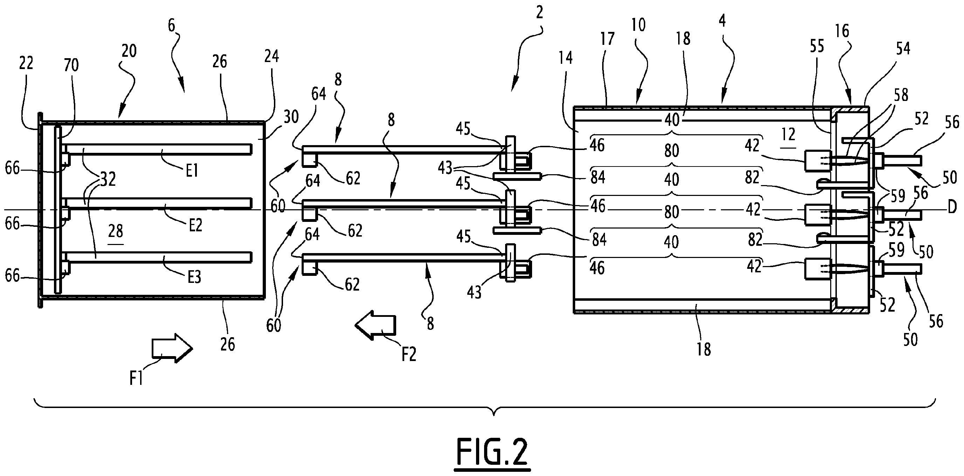

L'ensemble électronique 2 illustré sur les figures 1 et 2 comprend un coffre 4, un tiroir 6 insérable de manière amovible dans le coffre 4 et des cartes 8 électroniques insérables de manière amovible dans le tiroir 6, et dénommées par la suite cartes filles 8.

Trois cartes filles 8 sont représentées sur la figure 2, une seule étant visible sur la figure 1. L'ensemble électronique 2 peut comprendre un nombre différent de cartes électroniques, en particulier un nombre supérieur à trois.

Le coffre 4 est par exemple un coffre d'une armoire électrique ou d'une baie électronique comprenant une pluralité de coffres. L'armoire électrique ou la baie électronique est disposée dans un bâtiment, un véhicule, notamment un véhicule ferroviaire, ou sur une machine-outil.

Le tiroir 6 est insérable dans le coffre 4 suivant une direction longitudinale D d'insertion.

Dans la suite de la description, les termes « avant » et « arrière » s'entendent par rapport à l'insertion du tiroir 6 dans le coffre 4 suivant la direction longitudinale D, de l'avant vers l'arrière suivant la flèche F1 sur les Figures 1 et 2, et à son extraction suivant la direction D, de l'arrière vers l'avant.

Le coffre 4 comprend un support de tiroir 10 délimitant un logement 12 de réception du tiroir 6 et présentant une ouverture avant 14 d'insertion du tiroir 6 dans le logement 12 suivant la direction longitudinale D et un support de connectique 16 fixé à l'arrière du support de tiroir 10 et fermant l'extrémité arrière du logement 12.

Le support de tiroir 10 comprend une carcasse externe 17 délimitant le logement 12 et des guides internes de tiroir 18, disposés à l'intérieur de la carcasse externe 17 pour l'insertion à coulissement du tiroir 6 dans le coffre 4.

Le tiroir 6 comprend une enveloppe 20 possédant une face avant 22, une face arrière 24 et des faces latérales 26 délimitant un espace 28 de réception des cartes filles 8. La face arrière 24 est munie d'une ouverture arrière 30 pour l'insertion des cartes filles 8 dans le tiroir 6. Le tiroir 6 comprend un emplacement E1, E2, E3 (figure 2) respectif pour chaque carte fille 8.

Chaque carte fille 8 est insérable dans le tiroir 6 à son emplacement E1, E2, E3 suivant la direction longitudinale D de l'arrière vers l'avant, par la face arrière 24 du tiroir 6, suivant la Flèche F2 sur les figures 1 et 2.

Le tiroir 6 comprend pour chaque carte fille 8 une paire de glissières 32 longitudinales fixées sur des faces latérales 26 opposées pour recevoir deux bords latéraux opposés (Figure 1) de la carte fille 8, et définissant un emplacement E1, E2, E3. Les glissières 32 sont espacées transversalement pour définir les emplacements E1, E2, E3 et reliée à l'enveloppe 20 par des poutres 34 transversales (figure 1).

L'insertion des cartes filles 8 dans le tiroir 6 et du tiroir 6 dans le coffre 4 assure le raccordement des masses électriques des cartes filles 8 à la masse électrique de l'ensemble électronique 2. A cet effet, les glissières 32, les poutres 34 et l'enveloppe 20 sont métalliques, et les guides 18 et la carcasse externe 17 sont métalliques, de façon à assurer une liaison électrique de mise à la masse électrique entre les cartes filles 8 et la carcasse externe 17, cette dernière constituant ou étant reliée à la masse électrique de l'ensemble électronique 2.

L'ensemble électronique 2 comprend des connecteurs de coffre 40. Chaque connecteur de coffre 40 comprend une première partie 42 de connecteur de coffre 40 fixée sur le support de connectique 16 et une deuxième partie 46 de connecteur de coffre 40 fixée sur un bord arrière 45 d'une carte fille 8.

Les premières parties 42 de connecteur de coffre 40 sont donc disposées dans le fond du coffre 4.

Les deuxièmes parties 46 de connecteur de coffre 40 sont fixées par exemple sur une façade 43 métallique fixée sur un bord arrière 45 de chaque carte fille 8.

Les première 42 et deuxième 46 parties de chaque connecteur de coffre 40 sont complémentaires. Une des première 42 et deuxième 46 parties de connecteur de coffre 40 est une partie femelle et l'autre est une partie mâle.

Les première 42 et deuxième 46 parties de chaque connecteur de coffre 40 sont disposées de façon à se connecter en s'enfichant l'une dans l'autre lors de l'insertion du tiroir 6 équipé des cartes filles 8 dans le coffre 4.

Inversement, l'extraction du tiroir 6 provoque la séparation des première 42 et deuxième 46 parties de connecteur de coffre 40.

L'ensemble électronique est donc à embrochage et débrochage automatiques.

L'ensemble électronique 2 comprend un câble 50 associé à chaque connecteur de coffre 40 et raccordé à la deuxième partie 46 de ce connecteur de coffre. Chaque câble 50 est blindé et fixé sur le support de connectique 16 par l'intermédiaire d'une bride 52 de fixation et de reprise de blindage.

Chaque bride 52 est fixée sur l'arrière du support de connectique 16. Plus spécifiquement, chaque bride 52 est fixée sur une rebord 54 du support de connectique 16 s'étendant vers l'arrière à partir d'une plaque 55 du support de connectique 16 fermant l'arrière de logement 12 et portant les premières parties 42 de connecteur de coffre 40. Chaque bride 52 est espacée longitudinalement de la plaque 55 du support de connectique 16.

Chaque câble 50 comprend une gaine 56 de blindage et des conducteurs 58 entourés par la gaine 56. La gaine 56 est fixée et raccordée à la bride 52 par l'intermédiaire d'une attache 59 de reprise de blindage. La gaine 56 s'interrompt au niveau de la bride 52. Les conducteurs 58 se prolongent hors de la gaine 56 entre la bride 52 et la plaque 55 du support de connectique 16, et sont raccordés à la première partie 42 du connecteur de coffre 40 associé au travers d'un orifice 61 de la plaque 55.

Chaque bride 52 est métallique et reliée électriquement au support de connectique 16. Le support de connectique 16 est métallique et reliée à la carcasse 17. Ainsi, chaque bride 52 relie la gaine 56 du câble 50 associé à la masse électrique de l'ensemble électronique 2.

L'ensemble électronique 2 comprend des connecteurs de tiroir 60. Chaque connecteur de tiroir 60 comprend une première partie de connecteur 62 fixée sur un bord avant 64 d'une carte fille 8 et une deuxième partie de connecteur 66 fixée dans l'espace 28 du tiroir 6.

Les première 62 et deuxième 66 parties de chaque connecteur de tiroir 50 sont complémentaires. Une des première 62 et deuxième 66 parties de connecteur de tiroir 60 est une partie femelle et l'autre est une partie mâle.

Les première 62 et deuxième 66 parties de chaque connecteur de tiroir 60 sont disposées de façon à se connecter en s'enfichant l'une dans l'autre lors de l'insertion de la carte fille 8 correspondante dans tiroir 6 suivant la flèche F2 sur les figures 1 et 2.

L'ensemble électronique 2 comprend une carte électronique 70, dénommée par la suite carte mère 70, fixée à l'intérieur du tiroir 6 à proximité de la face avant 22 du tiroir 6 opposée à la face arrière 24 munie de l'ouverture arrière 30 d'insertion des cartes filles 8. Les deuxièmes parties 66 de connecteur de tiroir 60 sont fixées sur la carte mère 70. Les cartes filles 8 insérées dans le tiroir 6 sont inter-connectées entre elles par l'intermédiaire de la carte mère 70 (figure 2).

L'ensemble électronique 2 comprend des moyens de protection électromagnétique des connecteurs de coffre 40.

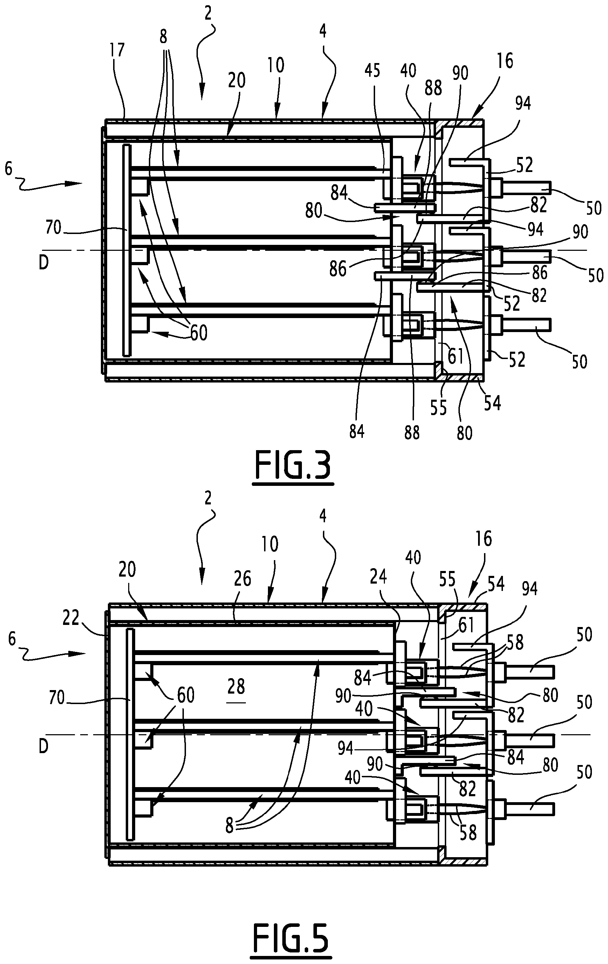

Plus spécifiquement, l'ensemble électronique 2 comprend des écrans 80 de protection électromagnétique. Chaque écran 80 est disposé à proximité d'un connecteur de coffre 40 et s'étend le long de celui-ci pour le protéger des perturbations électromagnétiques lorsque le tiroir 6 équipé des cartes 8 est inséré dans le coffre 4 (figure 3).

Chaque écran 80 est conducteur d'électricité et est relié électriquement, d'une part, au support de tiroir 10 et/ou au support de connectique 16 et, d'autre part, à une carte fille 8 et/ou au tiroir 6, lorsque le tiroir 6 équipé des cartes filles 8 est inséré dans le coffre 6. Chaque écran 80 réalise par conséquent une liaison électrique entre ces éléments.

Les cartes filles 8 sont disposées côte à côte et espacées transversalement. Chaque écran 80 s'étend suivant la direction longitudinale D entre deux connecteurs du coffre 40 lorsque le tiroir équipé des cartes filles 8 est inséré dans le coffre.

L'ensemble électronique 2 comprend ici deux écrans 80 s'étendant chacun respectivement dans un des deux intervalles entre les trois cartes filles 8.

Chaque écran 80 comprend une partie fixe 82 fixée sur le support de connectique 16 et une partie mobile 84 fixée sur une carte fille 8, complémentaires. La partie fixe 82 et la partie mobile 84 sont conductrices d'électricité et se connectent électriquement lorsque le tiroir 6 équipé des cartes filles 8 est inséré dans le coffre 4 (figure 3).

La partie fixe 82 de chaque écran 80 se présente sous la forme d'une plaque métallique mince sensiblement plane. Tel que représentée, elle s'étend vers l'arrière à partir de la plaque 55 du support de connectique 16 jusqu'à proximité ou au contact d'une bride 52, et possède une extension avant 86 s'étendant vers l'avant au travers de l'orifice 61 de la plaque 55 du support de connectique 16, dans le logement 12.

La partie mobile 84 de chaque cloison 80 se présente sous la forme d'une plaque métallique mince sensiblement plane. Elle s'étend le long du bord arrière 44 de la carte fille 8 et possède une extension arrière 88 s'étendant vers l'arrière à partir du bord arrière de la carte fille 8. Dans l'exemple illustré, la partie mobile 84 est fixée sur le côté de la façade 43 métallique de la carte fille 8 (figures 2 et 3).

La partie fixe 82 et la partie mobile 84 se connectent l'une à l'autre par l'intermédiaire de leurs extensions 86, 88 venant en contact lors de l'insertion du tiroir 6 dans le coffre 6.

Les parties fixe 82 et mobile 84 peuvent venir en contact directement.

En option, comme illustré sur les figures 2 et 3, un joint 90 de continuité électromagnétique (CEM) est disposé de façon que les parties fixe 82 et mobile 84 viennent en contact électrique par l'intermédiaire de ce joint 90. Le joint est disposé sur la partie fixe 82. En variante, le joint 90 est disposé sur la partie mobile 84.

En variante, le joint CEM est remplacé par un composant suffisamment conducteur sur le plan électrique sans être à proprement parler un joint CEM selon l'acception connue dans ce domaine.

En option, comme illustré sur les figures 2 et 3, au moins une bride 52 associée à un écran 80 venant au contact ou a proximité de la bride 52, comprend un cache 94 d'isolation électromagnétique s'étendant vers l'avant en direction du support de connectique 16, de façon que l'écran 80 et le cache 94 s'étendent de part et d'autre des conducteurs 58 du câble 50 associé. La bride 52, l'écran 80 et le support de connectique 16 délimitent un caisson autour des conducteurs 58 protégeant ceux-ci des perturbations électromagnétiques.

En fonctionnement, l'insertion de chaque carte fille 8 à son emplacement E1, E2, E3 dans le tiroir 6 provoque la connexion du connecteur de tiroir associé. L'insertion du tiroir 6 équipé de cartes filles 8 entraîne l'enfichage des connecteurs de coffre 40. Lorsque le tiroir 6 équipé des cartes filles 8 est inséré dans le coffre 4 (figure 3), chaque écran 80 s'étend le long d'un connecteur de coffre 40 associé et le protège des perturbations électromagnétiques.

Avantageusement, et comme cela est le cas dans le mode de réalisation illustré, chaque écran 80 s'étend entre deux connecteurs de coffre 40 adjacents en les séparant physiquement, i.e. en formant entre eux une cloison de séparation dans le fond du coffre 4 lorsque le tiroir 6 équipé des cartes 8 est inséré dans le coffre 4 (figure 3). Chaque écran 80 délimite à l'intérieur du coffre 4 deux compartiments séparés, un pour chacun des connecteurs de coffre 40 entre lesquels il s'étend. Ainsi, cet écran joue également le rôle d'une cloison qui vient physiquement séparer les différents types d'ondes électromagnétiques émanant des signaux électriques circulants dans les fils liés au connecteur de part et d'autre de cette cloison.

Dans l'exemple illustré, chaque écran 80 s'étend sensiblement sur toute la hauteur interne du coffre 4 (figure 1) prise suivant une direction transversale pour assurer une séparation efficace. Comme illustré sur la figure 1, la partie fixe 82 de chaque écran 80 s'étend sensiblement sur toute la hauteur du logement de câblage délimité à l'arrière du support de connectique 16 par le rebord 54 du support de connectique 16 et la partie mobile 84 de chaque cloison 80 s'étend sensiblement sur toute la hauteur du logement de tiroir 12 définit par le support de tiroir 10.

L'écran 80 étant conducteur d'électricité et relié électriquement d'une part au support de connectique 16, et ainsi au support de tiroir 10, et, d'autre part, à la masse électrique d'une carte fille 8 ou au tiroir 6, définit une protection contre les perturbations électromagnétiques provenant des autres connecteurs de coffre 40 et de l'extérieur.

Grâce à l'invention, il est possible d'utiliser des connecteurs de coffre à faible coût, par exemple conformes au standard F48 (DIN41612), adaptés à des connections en aveugle aisées, tout en protégeant efficacement les connecteurs de coffre 40 des perturbations électromagnétiques des autres connecteurs de coffre 40 et de l'extérieur.

Les écrans 80 en deux parties (partie fixe 82 et partie mobile 84) permettent de prévoir une partie protégeant la première partie du connecteur de coffre et sa connectique associée (câble 50 et ses conducteurs 58) et une partie protégeant la deuxième partie du connecteur de coffre 40.

L'invention n'est pas limitée au mode de réalisation décrit en référence aux figures 1 à 3.

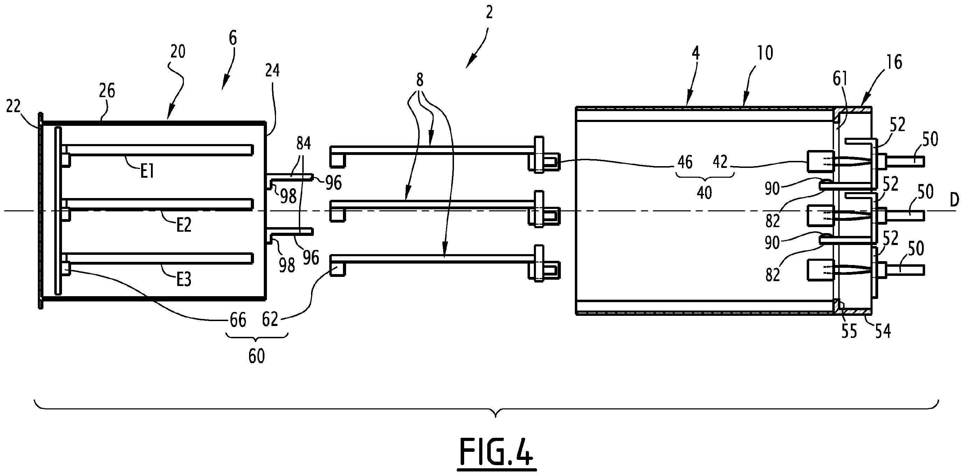

Le mode de réalisation des figures 4 et 5 diffère de celui des figures 1 à 3 en ce que les parties mobiles 84 sont fixés sur la face arrière du tiroir 6 au lieu d'être fixés sur les cartes filles 8.

Chaque partie mobile 84 comprend une portion de protection 96 prévue pour former écran de protection et une portion de fixation 98 faisant un angle entre elles. La portion de protection et la portion définissent une forme en « L ». Le pied de la forme en « L » est constitué par la portion de fixation 98, et la hampe par la portion de protection 96. En variante, il est possible de prévoir une partie mobile 84 en forme générale de « T ». Dans ce cas, la portion de protection définit la hampe et la portion de fixation définit la barre de la forme en « T ».

Dans ce mode de réalisation, les écrans 80 en deux parties (partie fixe 82 et partie mobile 84) prévues sur le tiroir 6 et le coffre 4 sont mis en place même en l'absence de carte fille 8 associée.

D'autres modes de réalisation ou variante sont encore possibles.

Ainsi, il est possible de combiner le mode de réalisation des figures 1 à 3 avec celui des figures 4 et 5 en prévoyant des parties mobiles d'écran fixées sur des cartes et des parties mobiles d'écran fixées sur le tiroir.

Dans une variante possible, un ou plusieurs écran(s) de protection électromagnétique est(sont) prévu(s) en une seule partie. Cette partie peut être prévue fixe et fixée sur le coffre, ou mobile et fixée sur une carte ou sur le tiroir. Si elle est fixée sur le coffre, elle vient en contact électrique avec le tiroir lors de son insertion dans le coffre ou en contact électrique avec une partie conductrice de la carte reliée à la masse de cette carte. Si elle est fixée sur la carte ou le tiroir, elle vient en contact électrique avec le coffre lors de l'insertion du tiroir dans le coffre.

De manière générale, des écrans en une partie ou des parties d'écran en plusieurs parties peuvent être prévu(e)s sur le coffre et/ou le tiroir pour la protection de connecteurs de coffre associés à des cartes dépourvue d'écran ou de parties d'écran ou munies de parties d'écran.

Ainsi, l'invention concerne de manière générale un ensemble électronique comprenant le coffre et le tiroir, qu'il soit ou non pré-équipé des cartes électroniques. Elle concerne bien entendu également des ensembles électroniques comprenant un coffre, un tiroir et des cartes électroniques.

Par ailleurs, il est possible de prévoir des écrans en nombre limité, situés uniquement de part et d'autre des connecteurs de coffre nécessitant une immunité électromagnétique élevée, du fait du type de connectique. Les connecteurs de coffre réalisant des connexions réseau de transmission de signaux codant des données, du type Ethernet nécessite généralement une protection électromagnétique accrue. Il est par exemple possible de protéger les connecteurs de coffre de transmission de donnée des connecteurs de coffre de transmission de puissance.

Il est également possible de prévoir un écran associé à un connecteur de coffre d'extrémité, de façon que l'écran ne s'étend pas entre deux connecteurs de coffre. Par exemple, dans les modes de réalisation des figures 1 à 3 et 4 et 5, un écran supplémentaire pourrait être associé au connecteur de coffre 40 situé en bas sur les figures 1 et 3, 4 et 5, pour le protéger des perturbations extérieures.

Il est encore possible de prévoir des caches additionnels uniquement pour les connecteurs de coffre nécessitant une protection électromagnétique élevée.

Par ailleurs, dans les modes de réalisation des figures 1 à 3 et 4 et 5, les connecteurs de tiroir et les connecteurs de coffre sont disposés sur des bords avant et arrière opposés des cartes électroniques.

Dans un autre mode de réalisation possible correspondant à un ensemble électronique analogue à celui divulgué dans le brevet EP 1 732 374, les premières parties des connecteurs de tiroir et des connecteurs de coffres sont disposées sur le même bord arrière des cartes filles, de façon que chaque carte fille puisse être insérée dans le tiroir préalablement inséré dans le coffre, l'insertion de la carte fille 8 se faisant suivant la direction longitudinale D de l'avant vers l'arrière en embrochant simultanément les première et deuxième parties du connecteur de tiroir et les première et deuxième partie du connecteur de coffre suivant la direction longitudinale D, et dans la même direction.

L'invention s'applique à de nombreux domaines, et notamment dans le domaine des transports, dont le domaine du ferroviaire, l'ensemble électronique étant embarqué ou non.

## Revendications

1. Ensemble électronique (2) du type comprenant :
- un tiroir (6) comprenant des emplacements (E1, E2, E3) de réception de cartes électroniques (8) insérables de manière amovible dans le tiroir (6) ;
- un coffre (4) comprenant un support de tiroir (10) présentant une ouverture d'insertion (14) à l'avant du support de tiroir (10) et un support de connectique (16) à l'arrière du support de tiroir (10), le tiroir (6) étant insérable de manière amovible dans le support de tiroir (10) de l'avant vers l'arrière, suivant une direction longitudinale (D)
- une première partie (42) de connecteur de coffre (40) associé à chaque emplacement (E1, E2, E3) de carte (8), fixée sur le support de connectique (16) et prévue pour être enfichée avec une deuxième partie (46) de connecteur de coffre (40) fixée sur une carte (8) du fait de l'insertion du tiroir (6) équipé de la carte (8) dans le support de tiroir (10),
**caractérisé en ce qu'**il comprend au moins un écran de protection électromagnétique prévu pour être adjacent à une première partie (42) de connecteur de coffre (40) et propre à réaliser une liaison électrique entre le support de tiroir (10) ou le support de connectique (16) et une carte disposée dans l'emplacement associée à la première partie (42) de connecteur de coffre (40) lorsque le tiroir (6) est inséré dans le coffre (4).

2. Ensemble électronique selon la revendication 1, dans lequel l'écran (80) s'étend vers l'arrière et/ou vers l'avant à partir du support de connectique (16) par rapport à la direction longitudinale (D).

3. Ensemble électronique selon la revendication 1 ou 2, dans lequel l'écran est configuré pour séparer physiquement deux premières parties connecteurs de coffre (40) adjacentes en définissant entre eux une cloison de séparation dans le fond du coffre (4).

4. Ensemble électronique selon l'une quelconque des revendications précédentes, dans lequel l'écran comprend au moins une partie fixe (82) fixée sur le support de connectique (16).

5. Ensemble électronique selon l'une quelconque des revendications précédentes, dans lequel l'écran (80) comprend au moins une partie mobile (84) fixée sur une carte (8) ou sur le tiroir (4).

6. Ensemble électronique selon les revendications 4 et 5 prises ensemble, dans lequel la partie fixe (82) et la partie mobile (84) sont complémentaires et se connectent électriquement lors de l'insertion du tiroir (6) équipé des cartes (8) dans le coffre (4) pour former l'écran (80).

7. Ensemble électronique selon la revendication 6, comprenant un joint de continuité électromagnétique (90) disposé de façon que la partie fixe (82) et la partie mobile (84) se connectent électriquement par l'intermédiaire de ce joint de continuité électromagnétique (90).

8. Ensemble électronique selon la revendication 7, dans lequel le joint de continuité électromagnétique (90) est disposé sur la partie fixe (82) ou sur la partie mobile (84).

9. Ensemble électronique selon l'une quelconque des revendications précédentes, comprenant un écran comprend une pièce comprenant une portion de protection (96) prévue pour s'étendre le long d'un connecteur de coffre (40) et une portion de fixation (98) de la portion de protection, faisant un angle avec la portion de protection, notamment un angle d'environ 90°.

10. Ensemble électronique selon la revendication 9, dans lequel la portion de protection (96) et la portion de fixation (98) définissent une forme en « T » ou en « L ».

11. Ensemble électronique selon l'une quelconque des revendications précédentes, comprenant un écran (80) comprenant une plaque sensiblement plane.

12. Ensemble électronique selon l'une quelconque des revendications précédentes, comprenant un écran (80) s'étendant sensiblement sur toute la hauteur interne du coffre (4), prise suivant une direction transversale.

13. Ensemble électronique selon l'une quelconque des revendications précédentes, comprenant au moins un câble (50) blindé et fixé sur le support de connectique (16) par l'intermédiaire d'une bride (52) de fixation et de reprise de blindage.

14. Ensemble électronique selon la revendication 13, dans lequel la bride (52) de fixation et de reprise de blindage comprend un cache (94) d'isolation électromagnétique s'étendant vers l'avant en direction du support de connectique (16), suivant la direction longitudinale (D), de façon que l'écran (80) et le cache (94) s'étendent de part et d'autre du câble (50) associé.

15. Ensemble électronique selon l'une quelconque des revendications précédentes, comprenant au moins une carte (8) électronique insérable dans un emplacement (E1, E2, E3) du tiroir (6) et comprenant une deuxième partie (46) de connecteur de coffre (40) complémentaire de la première partie de connecteur de coffre (42) associée à l'emplacement (E1, E2, E3).

16. Carte électronique pour la réalisation d'un ensemble électronique selon la revendication 5, comprenant une deuxième partie (46) de connecteur de coffre (40) complémentaire d'une première partie (42) de connecteur de coffre (42) associée à un emplacement (E1, E2, E3) du tiroir (6), et au moins une partie mobile (84) d'écran de protection électromagnétique adjacente à la deuxième partie (46) de connecteur de coffre (40).

17. Utilisation d'un ensemble électronique selon l'une quelconque des revendications 1 à 15 pour la connexion d'une carte électronique.

## Patentansprüche

1. Elektronische Einrichtung (2) des Typs, der aufweist:
- ein Einschubteil (6), welches Einbaustellen (E1, E2, E3) zur Aufnahme von elektronischen Karten (8) aufweist, welche auf herausnehmbare Weise in das Einschubteil (6) einsetzbar sind,
- einen Kasten (4), welcher eine Einschubteil-Halterung (10) aufweist, welche eine Einsetz-Öffnung (14) an der Vorderseite der Einschubteil-Halterung (10) und eine Verbindungs-Halterung (16) an der Hinterseite der Einschubteil-Halterung (10) hat, wobei das Einschubteil (6) auf herausnehmbare Weise von der Vorderseite zu der Hinterseite hin entlang einer longitudinalen Richtung (D) in die Einschubteil-Halterung (10) einsetzbar ist,
- einen ersten Teil (42) eines mit jeder Einbaustelle (E1, E2, E3) der Karte (8) assoziierten Kasten-Verbinders (40), der an der Verbindungs-Halterung (16) befestigt ist und vorgesehen ist, um mit einem zweiten Teil (46) des Kasten-Verbinders (40) im Steckeingriff zu sein, der an einer Karte (8) befestigt ist, infolge des Einsetzens des Einschubteils (6), welches mit der Karte (8) ausgestattet ist, in die Einschubteil-Halterung (10),
**gekennzeichnet dadurch, dass**
sie mindestens eine Abschirmung zum elektromagnetischen Schutz aufweist, die vorgesehen ist, um benachbart zu einem ersten Teil (42) des Kasten-Verbinders (40) zu sein, und die geeignet ist, um eine elektrische Verbindung zwischen der Einschubteil-Halterung (10) oder der Verbindungs-Halterung (16) und einer Karte, welche in der Einbaustelle angeordnet ist, welche mit dem ersten Teil (42) des Kasten-Verbinders (40) assoziiert ist, herzustellen, wenn das Einschubteil (6) in den Kasten (4) eingesetzt ist.

2. Elektronische Einrichtung gemäß Anspruch 1, wobei sich die Abschirmung (80) ausgehend von der Verbindungs-Halterung (16) aus bezüglich der longitudinalen Richtung (D) zur Hinterseite und/oder zur Vorderseite hin erstreckt.

3. Elektronische Einrichtung gemäß Anspruch 1 oder 2, wobei die Abschirmung eingerichtet ist, um physisch zwei benachbarte erste Teile des Kasten-Verbinders (40) zu trennen mittels Definierens einer Trennwand zwischen ihnen unten an dem Kasten (4).

4. Elektronische Einrichtung gemäß irgendeinem der vorherigen Ansprüche, wobei die Abschirmung mindestens einen festen Teil (82) aufweist, der an der Verbindungs-Halterung (16) befestigt ist.

5. Elektronische Einrichtung gemäß irgendeinem der vorherigen Ansprüche, wobei die Abschirmung mindestens einen bewegbaren Teil (84) aufweist, der an einer Karte (8) oder an dem Einschubteil (4) befestigt ist.

6. Elektronische Einrichtung gemäß einer Kombination der Ansprüche 4 und 5, wobei der feste Teil (82) und der bewegbare Teil (84) komplementär sind und sich elektrisch verbinden infolge des Einsetzens des Einschubteils (6), das mit den Karten (8) ausgestattet ist, in den Kasten (4), um die Abschirmung (80) zu bilden.

7. Elektronische Einrichtung gemäß Anspruch 6, welcher eine Verbindung elektromagnetischer Kontinuität (90) aufweist, welche auf eine Weise angeordnet ist, dass der feste Teil (82) und der bewegbare Teil (84) sich elektrisch verbinden mittels dieser Verbindung elektromagnetischer Kontinuität (90).

8. Elektronische Einrichtung gemäß Anspruch 7, in welchem die Verbindung elektromagnetischer Kontinuität (90) an dem festen Teil (82) oder an dem bewegbaren Teil (84) angeordnet ist.

9. Elektronische Einrichtung gemäß irgendeinem der vorherigen Ansprüche, aufweisend eine Abschirmung, welche ein Teil aufweist, das einen Schutzabschnitt (96), der vorgesehen ist, um sich entlang eines Kasten-Verbinders (40) zu erstrecken, und einen Abschnitt zur Befestigung (98) des Schutzabschnittes aufweist, der einen Winkel mit dem Schutzabschnitt, insbesondere einen Winkel von etwa 90°, einschließt.

10. Elektronische Einrichtung gemäß Anspruch 9, wobei der Schutzabschnitt (96) und der Abschnitt zur Befestigung (98) eine Form eines "T" oder eines "L" definieren.

11. Elektronische Einrichtung gemäß irgendeinem der vorherigen Ansprüche, aufweisend eine Abschirmung (80), die eine Platte aufweist, die im Wesentlichen eben ist.

12. Elektronische Einrichtung gemäß irgendeinem der vorherigen Ansprüche, aufweisend eine Abschirmung (80), die sich im Wesentlichen über die gesamte innere Höhe des Kastens (4) erstreckt, die einer transversalen Richtung folgend genommen ist.

13. Elektronische Einrichtung gemäß irgendeinem der vorherigen Ansprüche, aufweisend mindestens ein Kabel (50), das abgeschirmt ist und an der Verbindungs-Halterung (16) befestigt ist mittels einer Brücke (52) zur Befestigung und zur Aufnahme der Abschirmung.

14. Elektronische Einrichtung gemäß Anspruch 13, wobei die Brücke (52) zur Befestigung und zur Aufnahme der Abschirmung eine Abdeckung (94) zur elektromagnetischen Isolation aufweist, die sich zur Vorderseite in Richtung der Verbindungs-Halterung (16) entlang der longitudinalen Richtung (D) in einer Weise erstreckt, dass die Abschirmung (80) und die Abdeckung (94) sich beiderseits des assoziierten Kabels (50) erstrecken.

15. Elektronische Einrichtung gemäß irgendeinem der vorherigen Ansprüche, aufweisend mindestens eine elektronische Karte (8), die in eine Einbaustelle (E1, E2, E3) des Einschubteils (6) einsetzbar ist und die einen zweiten Teil (46) des Kasten-Verbinders (40) aufweist, der komplementär zu dem ersten Teil des Kasten-Verbinders (42) ist, der mit der Einbaustelle (E1, E2, E3) assoziiert ist.

16. Elektronische Karte für die Verwirklichung einer elektronischen Einrichtung gemäß Anspruch 5, aufweisend einen zweiten Teil (46) des Kasten-Verbinders (40), der komplementär zu einem ersten Teil (42) des Kasten-Verbinders (42) ist, der mit einer Einbaustelle (E1, E2, E3) des Einschubteils (6) assoziiert ist, und mindestens einen bewegbaren Teil (84) der Abschirmung zum elektromagnetischen Schutz, der benachbart zu dem zweiten Teil (46) des Kasten-Verbinders (40) ist.

17. Verwendung einer elektronischen Einrichtung gemäß irgendeinem der Ansprüche 1 bis 15 für die Verbindung einer elektronischen Karte.

## Claims

1. Electronic assembly (2) of the type comprising:
- a drawer (6) comprising sites (E1, E2, E3) for receiving electronic boards (8) that can be removably inserted into the drawer (6);
- a compartment (4) comprising a drawer holder (10) having an insertion opening (14) at the front of the drawer holder (10) and a connector holder (16) at the rear of the drawer holder (10), the drawer (6) being able to be removably inserted into the drawer holder (10) from front to back, in a longitudinal direction (D);
- a first part (42) of a compartment connector (40) associated with each site (E1, E2, E3) of board (8), fastened on the connector holder (16) and provided to be plugged in with a second part (46) of the compartment connector (40) fastened on a board (8) due to the insertion of the drawer (6) equipped with the board (8) into the drawer holder (10),
**characterized in that** it comprises at least one electromagnetic protection screen provided to be adjacent to a first part (42) of the compartment connector (40) and able to produce an electrical connection between the drawer holder (10) or the connector holder (16) and a board arranged in the site associated with the first part (42) of the compartment connector (40) when the drawer (6) is inserted into the compartment (4).

2. Electronic assembly according to claim 1, wherein the screen (80) extends backward and/or forward from the connector holder (16) relative to the longitudinal direction (D).

3. Electronic assembly according to claim 1 or 2, wherein the screen is configured to physically separate two adjacent first parts of the compartment connector (40) by defining a separating partition between them in the bottom of the compartment (4).

4. Electronic assembly according to any one of the preceding claims, wherein the screen comprises at least one stationary part (82) fastened on the connector holder (16).

5. Electronic assembly according to any one of the preceding claims, wherein the screen (80) comprises at least one mobile part (84) fastened on a board (8) or on the drawer (4).

6. Electronic assembly according to claims 4 and 5 taken together, wherein the stationary part (82) and the mobile part (84) are complementary and connect electrically upon insertion of the drawer (6) equipped with the boards (8) into the compartment (4) to form the screen (80).

7. Electronic assembly according to claim 6, comprising an electromagnetic continuity seal (90) arranged so that the stationary part (82) and the mobile part (84) connect electrically via said electromagnetic continuity seal (90).

8. Electronic assembly according to claim 7, wherein the electromagnetic continuity seal (90) is arranged on the stationary part (82) or on the mobile part (84).

9. Electronic assembly according to any one of the preceding claims, comprising a screen comprises a piece comprising a protective portion (96) provided to extend along a compartment connector (40) and a portion (98) for fastening the protective portion, forming an angle with the protective portion, in particular an angle of about 90°.

10. Electronic assembly according to claim 9, wherein the protective portion (96) and the fastening portion (98) define a "T" or "L" shape.

11. Electronic assembly according to any one of the preceding claims, comprising a screen (80) comprising a substantially planar plate.

12. Electronic assembly according to any one of the preceding claims, comprising a screen (80) extending substantially over the entire internal height of the compartment (4) considered in a transverse direction.

13. Electronic assembly according to any one of the preceding claims, comprising at least one shielded cable (50), which is fastened on the connector holder (16) via a mounting and take-up shielding clip (52).

14. Electronic assembly according to claim 13, wherein the mounting and take-up shielding clip (52) comprises an electromagnetic insulation cover (94) extending forward toward the connector holder (16), in the longitudinal direction (D), so that the screen (80) and the cover (94) extend on either side of the associated cable (50).

15. Electronic assembly according to any one of the preceding claims, comprising at least one board (8) that can be inserted into a site (E1, E2, E3) of the drawer (6) and comprising a second part (46) of a compartment connector (40) complementary to the first part (42) of a compartment connector associated with the site (E1, E2, E3).

16. A board for producing an electronic assembly according to claim 5, comprising a second part (46) of a compartment connector (40) complementary with a first part (42) of a compartment connector (40) associated with a site (E1, E2, E3) of the drawer (6), and at least one mobile electromagnetic protective screen part (84) adjacent to the second part (46) of a compartment connector (40).

17. A use of an electronic assembly according to any one of claims 1 to 15 to connect a board.
